(19) **Europäisches Patentamt / European Patent Office / Office européen des brevets**

(11) **EP 2 755 087 B1**

(12) **EUROPEAN PATENT SPECIFICATION**

(45) Date of publication and mention
of the grant of the patent:
**14.10.2015 Bulletin 2015/42**

(51) Int Cl.:
*G03F 7/00* (2006.01)          *B41N 1/12* (2006.01)
*G03F 7/033* (2006.01)        *G03F 7/11* (2006.01)

(21) Application number: **12830272.6**

(22) Date of filing: **22.08.2012**

(86) International application number:
**PCT/JP2012/071195**

(87) International publication number:
**WO 2013/035535 (14.03.2013 Gazette 2013/11)**

(54) **FLEXOGRAPHIC PRINTING ORIGINAL PLATE AND WATER-DEVELOPABLE PHOTOSENSITIVE RESIN LAMINATE**

FLEXOGRAPHISCHE ORIGINALDRUCKPLATTE SOWIE IN WASSER ENTWICKELBARES LICHTEMPFINDLICHES HARZLAMINAT

PLAQUE ORIGINALE D'IMPRESSION FLEXOGRAPHIQUE ET STRATIFIÉ DE RÉSINE PHOTOSENSIBLE DÉVELOPPABLE À L'EAU

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.09.2011  JP 2011196736**
**31.10.2011  JP 2011238205**

(43) Date of publication of application:
**16.07.2014 Bulletin 2014/29**

(73) Proprietor: **Toyobo Co., Ltd.**
**Osaka-shi**
**Osaka 530-8230 (JP)**

(72) Inventors:
• **YOSHIMOTO, Kazuya**
**Okayama-shi,**
**Okayama 704-8194 (JP)**

• **KAWAKAMI, Tetsuma**
**Okayama-shi,**
**Okayama 704-8194 (JP)**
• **YONEKURA, Hiromichi**
**Okayama-shi,**
**Okayama 704-8194 (JP)**
• **TAKAHASHI, Satoshi**
**Okayama-shi,**
**Okayama 704-8194 (JP)**

(74) Representative: **Müller-Boré & Partner**
**Patentanwälte PartG mbB**
**Friedenheimer Brücke 21**
**80639 München (DE)**

(56) References cited:
**WO-A1-2011/013601      JP-A- H0 572 740**
**JP-A- H09 138 499        JP-A- 2004 295 120**
**JP-A- 2005 077 503       JP-A- 2008 216 842**
**JP-A- 2011 033 690**

**Description**

Technical Field of the Invention

The present invention relates to a flexographic printing original plate which is developable by water and which uses the latex having a high gelation degree in a photosensitive resin layer. More particularly, the present invention relates to a flexographic printing original plate which can suppress the thickening of dots in a printing plate in spite of having a solvent-resisting ink property. The present invention also relates to a laminate of photosensitive resin used in a water-developable photosensitive resin letterpress printing original plate, which is used for the manufacture of a relief plate for printing.

Background Art

Flexographic printing has been advantageously used for printing on a printing medium having relatively rough surfaces represented by paper such as corrugated cardboard, paper ware or envelope utilizing the characteristics that its printing plate is soft and flexible. On the other hand, for printing on a printing medium having flat and smooth surfaces such as a plastic film used in package materials, offset printing and gravure printing have been used as the main printing methods due to their high printing quality. As such, different printing methods have been used depending upon different printing media.

In recent years however, due to the improvements in the performances of printing machines and peripheral devices thereof in flexographic printing, printing quality of flexography has been significantly enhanced. As a result, flexographic printing has been frequently used even when the printing medium is a plastic film.

Generally, an ink used for a plastic film is different from an ink used for paper. Since wetting property and permeating property of film are inferior to those of paper, the ink to be used for film is compounded with large amount of an organic solvent such as propyl acetate and a crosslinking monomer as compared with the ink to be used for paper. The organic solvent and the crosslinking monomer as such permeate into a plate material during the printing and cause serious problems such as swelling and strength lowering of the plate. Accordingly, a printing plate having a high solvent-resisting ink property is needed in case of printing on a film.

Up to now, several water-developable plates wherein the solvent resistance of a plate is enhanced for the film printing have been reported already (see, for example,

Patent Documents 1 and 2). Any of them is characterized in using the crosslinked latex as a main component. Due to the use of already-gelled latex as a main component, invasion of the solvent into the latex can be prevented and, as a result thereof, resistance of the plate to solvent is enhanced.

However, when the gelled latex is used as a main component, there has been a problem that the dot size of a printing plate becomes larger than the dot size of a negative film. That is because, when the already-crosslinked latex is used, the latex particles are incorporated into a crosslinked matrix even by slight scattered light generated upon the main exposure to light and are insolubilized whereby they cannot be washed out in a developing step. When the dot size of a printing plate becomes large, the dot size of a printed thing inevitably becomes large and it is not possible to give a printed thing in high quality.

As such, there has been no printing plate which can achieve both of the solvent-resisting ink property and the high-quality printing in a water-developable flexographic plate and there has been a demand for the development therefor.

In a laminate of photosensitive resin for letterpress printing original plate, it is general that a support, an adhesive layer and a photosensitive resin layer are laminated, an adhesion-preventing layer is further laminated thereon for a purpose of preventing the adhesion of the surface of the photosensitive resin layer and then a cover film is furthermore laminated thereon.

A plate-making step for preparing a printing plate from a laminate of photosensitive resin is usually conducted as follows. Thus, firstly, a cover film on the upper layer of the crude plate is released, an original image film is placed thereon followed by tightly adhering *in vacuo* and then active ray is irradiated so that a part of the photosensitive resin layer is exposed to the ray and cured. After that, the original image film is released and the uncured part is removed using a developer.

In recent years, there has been a demand for a relief for printing by which finer pattern can be correctly reproduced and there has been also a demand for a property by which the same size as in the original image film is reproduced in a printed thing. In the conventional laminate of photosensitive resin wherein polyvinyl alcohol is used in an adhesion-preventing layer (see, for example, Patent Document 3), thickening of the size due to the printing pressure is resulted whereby there is a problem that the pattern of a printed thing is thicker than that of the original image film.

As to an art for solving the above problem, there are, for example, the publicly known ones such as Patent Document 4 and Patent Document 5. However, the art as such relates to a flexographic printing original plate using an aqueous ink and using a water-developable synthetic rubber-type photosensitive resin layer containing hydrophilic polymer or liquid rubber, synthetic rubber, water-dispersible latex, photopolymerizing unsaturated compound and photopolymerization initiator. Thus, it is not such an art which can be applied to a laminate of photosensitive resin for a photosensitive resin letterpress printing original plate using an oily ink.

On the other hand, there is a known art such as Patent Document 6 and Patent Document 7 in a photosensitive resin letterpress printing plate. In such an art however, an adhesion-preventing layer contains a light absorber having absorption in an active ray region of the photosensitive resin layer and, as a result, exposure amount of the photosensitive resin plate per unit area to light decreases whereby there is a problem that the time for curing becomes long. Moreover, in a photosensitive resin plate prepared using the above art, variation is noted in the reproducibility of dots and fine lines merely by normal main exposure to light whereby there is a problem that back exposure to light is necessary.

In addition, there has been investigated an art wherein a cap layer is provided between a photosensitive resin layer and an adhesion-preventing layer so that a pattern of a relief for printing can be reproduced as finer top faces. Since the cap layer of the relief top faces can be finely shaved in a plate-making step, it is now possible to prepare a sharper relief for printing by providing one or two cap layer(s). However, according to such a method, there is a problem that a processing cost in a manufacturing cost becomes very high.

Further investigation has been done for an art to lower the crosslinking density of a photosensitive resin layer so that the tips of the cured dots are shaved by a developing step during the development of a photosensitive resin plate. Since each of the cured patterns can be finely shaved out in a developing step, it is possible to give a sharper relief for printing. However, in such a method, there is a problem in terms of printing durability because of lowering of the strength of the relief itself in addition to a problem in the reproducibility of the relief.

Moreover, there is a method wherein pattern size printed on a subject is adjusted by means of previously changing the dot heights in the image part in a step of preparing a relief for printing so that the pattern of a printed thing is made identical with that of an original image film. However, although such a method is effective in a plate-making step for a relief for printing particularly for digital image formation, there is a problem that the method cannot be applied for a plate-making step of a relief for printing in an analog system.

Prior Art Documents

Patent Documents

Patent Document 1: Japanese Patent Application Laid-Open (JP-A) No. 2005-77503
Patent Document 2: WO 2004/090638
Patent Document 3: Japanese Patent Application Laid-Open (JP-A) No. 110010/77
Patent Document 4: Japanese Patent Application Laid-Open (JP-A) No. 2004-295120
Patent Document 5: Japanese Patent Application Laid-Open (JP-A) No. 72740/93
Patent Document 6: Japanese Patent Application Laid-Open (JP-A) No. 2003-295422
Patent Document 7: Japanese Patent Application Laid-Open (JP-A) No. 2004-264509

Disclosure of the Invention

Problem that the Invention is to Solve

The present invention has been created in view of the problems in the prior art as such. Thus, the first object of the present invention is that, in a flexographic printing original plate being developable by water wherein a latex having high gelation degree is used in a photosensitive resin layer, both of the solvent-resisting ink property and the suppression of thickening of dots in a printing plate can be achieved. The second object of the present invention is to provide a laminate of photosensitive resin for letterpress printing original plate in which not only the problems in the prior art method can be solved but also the plate surface adhesion being a problem in view of quality in the conventional product and happening when polyvinyl alcohol is used in an adhesion-preventing layer can be solved and is to particularly provide a water-developable laminate of photosensitive resin in which a sharp pattern can be reproduced from an original image film when the above laminate of photosensitive resin is used as a printing original plate.

Means for Solving the Problem

The present inventors have conducted extensive investigations for achieving those objects and, as a result, they have found that, when a cellulose derivative is used instead of polyvinyl alcohol which has been conventionally used in an adhesion-preventing layer formed on the surface of a photosensitive resin layer of a flexographic printing plate, permeability of oxygen to the photosensitive resin layer is significantly enhanced whereupon inhibition of polymerization by oxygen on the surface of the photosensitive resin layer effectively works whereby the part which has been insolubilized up to now even by scattered light is no longer cured and thickening of dots in the printing plate is suppressed. The present inventors have also found that the above objects can be achieved when a cellulose derivative is used in an adhesion-preventing layer which constitutes the laminate of the photosensitive resin.

Thus, the present invention has the constitutions of the following (1) to (10):

(1) A photosensitive flexographic printing original plate being developable by water in which at least a support, a photosensitive resin layer containing 25% by mass or more of latex having gelation degree of 55% or more and an characterized in that the adhesion-preventing layer contains a cellulose derivative.
(2) The flexographic printing original plate according to (1), wherein weight-average gelation degree of total latex in the photosensitive resin layer is 55% or more.
(3) The flexographic printing original plate according to (1) or (2), wherein the cellulose derivative is methyl cellulose.
(4) The flexographic printing original plate according to any of (1) to (3), wherein the adhesion-preventing layer contains, besides the cellulose derivative, a plasticizer which is a compound having 3 to 8 hydroxyl groups in a molecule and having number-average molecular weight of 120 to 1000.
(5) The flexographic printing original plate according to any of (1) to (4), wherein the dot diameter in 1% screen area with 150 LPI (line per inch) satisfies the following formula [I]:

$$(\text{Dot diameter on relief}) \leq (\text{Dot diameter on negative film})$$

$$[\text{I}]$$

Advantages of the Invention

Since the flexographic printing original plate of the present invention uses the latex of high gelation degree in a photosensitive resin layer, it is excellent in terms of a solvent-resisting ink property. In addition, since a cellulose derivative having a high oxygen permeation coefficient is used for an adhesion-preventing layer being used on the surface of a photosensitive resin layer, inhibition of polymerization by oxygen on the surface of the photosensitive resin layer effectively works, the part which has been insolubilized up to now even by scattered light in case the latex having high gelation degree is used is no longer cured and thickening of the dots in a printing plate is suppressed. In the water-developable laminate of photosensitive resin according to the present invention, a cellulose derivative is used in an adhesion-preventing layer which is exposed when a cover film of the laminate of photosensitive resin is released. The above adhesion-preventing layer corresponds to the surface to which an original image film is tightly adhered in a plate-making step for preparing a printing plate. The light which transmits the original image film and the adhesion-preventing layer cures the photosensitive resin layer. Up to now, polyvinyl alcohol has been used in an adhesion-preventing layer to prepare a relief for printing wherein the pattern of the original image film is faithfully reproduced. On the contrary, when a cellulose derivative is used in an adhesion-preventing layer, it is now possible to give a relief for printing which reproduces the pattern of the original image film more precisely. The degree of precise pattern of the relief can be confirmed by means of numerical process using a microscope followed by comparing. In comparison of the printed things, it is also noted that the case wherein a cellulose derivative is used in an adhesion-preventing layer gives a sharp printed image nearer the original image film than the case wherein the conventional polyvinyl alcohol is used in an adhesion-preventing layer.

Best Mode for Carrying Out the Invention

(Flexographic printing plate)

The flexographic printing original plate of the present invention has a constitution wherein at least a support, a photosensitive resin layer containing 25% by mass or more of latex having gelation degree of 55% or more, and an adhesion-preventing layer are successively laminated.

The support to be used for the original plate of the present invention is preferably made from a material being flexible and having a superior dimension stability, and examples thereof include: a support made of metal, such as steel, aluminum, copper and nickel, and a support made of a thermoplastic resin, such as a polyethylene terephthalate film, a polyethylene naphthalate film, a polybutylene terephthalate film and a polycarbonate film. Among these, the polyethylene terephthalate film, which has a superior dimension stability and a sufficiently high viscoelasticity, is in particular preferably used. The thickness of the support is set to 50 to 350 $\mu$m, preferably, to 100 to 250 $\mu$m, from the viewpoints of mechanical properties, shape stability and handling characteristics upon making a printing plate. Moreover, if necessary, in order to improve an adhesive property between the support and a photosensitive resin layer, an adhesive may be formed between them.

The photosensitive resin layer to be used for the original plate of the present invention is composed of essential components, such as a latex, a photopolymerizable unsaturated compound and a photopolymerization initiator, and desirable additives, such as a plasticizer, a thermal polymerization inhibitor, a dye, a pigment, an ultraviolet-ray absorbing agent, perfume, and an antioxidant. In the present invention, the photosensitive resin layer must be the one which is developable by using a water-based developer.

Latex is a main component of the photosensitive resin layer and is a component which constitutes the center of a printing plate. The characteristic feature of the present invention is that the latex particularly having a high gelation degree is used in a predetermined amount or more as the latex. When only a latex which is not gelled or has a low gelation degree is used, resistance to solvent is inferior and, in case the printing is conducted using an ink for film printing, swelling or cracking of the plate is resulted. On the other hand, when the latex having high gelation degree is used, although the solvent-resisting ink property usually increases, the latex is incorporated into the crosslinked matrix even by slight scattered light resulting in insoluble thing upon developing and, as a result, there is such a problem that the dot size of the printing plate becomes larger than that of the negative film. In accordance with the present invention, such a problem is dealt with by modifying the constituting components of the adhesion-preventing layer which will be mentioned later. Here, a latex is an emulsion in which a macromolecule such as a natural rubber, a synthetic rubber or a plastic is dispersed in the form of colloid in water through the action of an emulsifier, and it is classified, depending upon the type of production process, into (i) a natural rubber latex, which is a naturally occurring product due to vegetable metabolism, (ii) a synthetic rubber latex, which is synthesized by emulsion polymerization, and (iii) an artificial latex, which is prepared by emulsifying and dispersing a solid rubber in water. The latex used in the present invention, however, includes only (ii) the synthetic rubber latex and (iii) the artificial latex and excludes (i) the natural rubber latex.

The latex may comprise one kind of latex or may be composed of a mixture of plural kinds of latices. The weight-average gelation degree of total latex used in the photosensitive resin layer is preferred to be 55% or more, more preferred to be 65% or more, and further preferred to be 80% or more. When the gelation degree of the latex is less than the above, the plate is easily swollen when an ink for film printing is used. On the contrary, there is no limitation for the upper limit of the weight-average gelation degree of the latex and, although the more the gelation degree, the higher the solvent-resisting ink property, its upper limit is preferred to be 95%. Here, the value of the gelation degree of a latex is defined by the insolubility in toluene. Specifically, the gelation degree of a latex is determined by accurately weighing 3 g of a latex solution onto a PET film having a thickness of 100 $\mu$m, drying it at 100°C for 1 hour, subsequently immersing the film in a toluene solution at 25°C for 48 hours, then drying it at 110°C for 2 hours, and calculating the amount in % by weight of the insoluble.

As the latex to be used in the present invention, a latex having a gelation degree at a certain level or higher may be selected appropriately from among conventional latices. For example, a polybutadiene latex, a styrene-butadiene copolymer latex, an acrylonitrile-butadiene copolymer latex, a methyl methacrylate-butadiene copolymer latex, etc. can be used. Further, these latices may have been modified with (meth)acrylate, carboxy, etc. Here, because a variety of synthetic or natural latices as gelled latices are on the market, a proper one may be selected from among them as a gelled latex.

As a latex, an ungelled latex or a latex having a low gelation degree may also be used so far as the above latex having a high gelation degree is contained in more than the above predetermined amount. An ungelled latex is used in view of the ink transfer to a water-based ink. An ungelled latex may be selected appropriately from among conventionally known latices. For example, a polybutadiene latex, a styrene-butadiene copolymer latex, an acrylonitrile-butadiene copolymer latex or the like can be used. In particular, it is preferable, from the aforesaid point of view, to use an acrylonitrile-butadiene copolymer latex.

It is also necessary in the present invention to contain 25% by mass or more of the latex having the gelation degree of 55% or more. It is preferred to contain 35% by mass or more. When the amount of the latex contained therein is less than 25% by mass, the solvent-resisting ink property is insufficient. On the other hand, although there is no upper limit for the amount of the latex, it is preferred to be less than 60% by mass. When the amount of the latex is more than 60% by mass, developing by water may become difficult.

The adhesion-preventing layer used for the original plate of the present invention is provided for preventing the adhesion of a negative film to a photosensitive layer. For such a purpose, it is necessary that the adhesion-preventing layer is non-adhesive. It is also necessary that said layer can be removed by a water-based developer. In the present invention, the adhesion-preventing layer is characterized in containing a cellulose derivative. A cellulose derivative has 500-fold or more oxygen permeation coefficient as compared with polyvinyl alcohol which has been conventionally used for an adhesion-preventing layer and, as a result thereof, there is achieved such a function that oxygen is easily permeated to a photosensitive resin layer. When a cellulose derivative is used in an adhesion-preventing layer as in the present invention, inhibition of polymerization by oxygen on the photosensitive resin layer surface effectively works as compared with the conventionally-used ones and the part which has been insolubilized up to now even by scattered light is no longer cured. Accordingly, even when the latex of a high gelation degree is used in a photosensitive resin layer as in the present invention, an effect of suppressing the thickening of dots in a printing plate is achieved. Generally, an exposing step to light is carried out *in vacuo* in order to enhance the tight adhesion between a negative film and a photosensitive layer. When a cellulose derivative is used in an adhesion-preventing layer, slight oxygen *in vacuo* can be efficiently utilized.

Examples of the cellulose derivative include methyl cellulose, hydroxypropyl methyl cellulose, hydroxyethyl methyl cellulose, hydroxyethyl cellulose and hydroxypropyl cellulose. Amount of the cellulose derivative contained in an adhesion-preventing layer is preferred to be 50 to 100% by mass and more preferred to be 70 to 100% by mass.

An example of the component which can be contained in the adhesion-preventing layer other than the cellulose derivative is a plasticizer. A plasticizer is added for preventing generation of wrinkles and cracks in the adhesion-preventing layer even if handling of a printing plate is rough. As to a plasticizer, there may be used a compound having 3 to 8 hydroxyl groups in a molecule and having a number-average molecular weight of 120 to 1000. As a result of the use of a plasticizer having 3 to 8 hydroxyl groups, its compatibility with a cellulose derivative is enhanced and bleeding-out can be prevented. As a result of the use of a plasticizer having the number-average molecular weight of 120 to 1000, evaporation during the application can be suppressed and an excellent plasticizing effect can be achieved as well. To be more specific, there may be exemplified the compounds wherein hydroxyl groups in glycerol, trimethylolpropane or polyhydric alcohol are substituted with ethylene glycol, diethylene glycol, polypropylene glycol, or propylene glycol, etc. Among the above, a compound wherein hydroxyl groups in sorbitol are substituted with ethylene glycol (hexane-1,2,3,4,5,6-hexoxyethylenol) exhibits little bleeding out and can be advantageously used.

The flexographic printing original plate of the present invention can be laminated with a cover film besides the above-mentioned support, photosensitive resin layer and adhesion-preventing layer. As to the cover film, a polyester film can be advantageously used. As to the cover film, it is preferred to use such a one wherein the surface has been subjected to a matting treatment. It is also possible to apply an agent for adjusting the adhesive force to the cover film for adjusting the releasing force between the cover film and the adhesion-preventing layer.

Although there is no particular limitation for a method of preparing the flexographic printing original plate of the present invention, said plate is usually prepared as follows:

Firstly, a cellulose derivative is dissolved in a solvent and applied on a cover film (such as a PET film) and the solvent is evaporated therefrom. Separately, a photosensitive resin layer is formed on a support to prepare another laminate. The two laminates prepared as such are laminated with pressure and/or heat so that the photosensitive layer is made to be adjacent to the adhesion-preventing layer. Incidentally, after completion of the printing original plate, the cover film functions as a protective film for the surface of said plate.

A method for making printing plate from the printing original plate of the present invention is as follows. Thus, firstly, ultraviolet ray is irradiated from the side of a support using a light source of usually 300 to 400 nm such as high-voltage mercury lamp, ultrahigh-voltage mercury lamp, ultraviolet lamp or chemical lamp. After that, a cover film is removed from the printing plate in case a cover film is present. Then a negative film is tightly adhered onto the photosensitive resin layer, ultraviolet ray is irradiated and then photo-curing is done by means of photopolymerization. After that, the unexposed area to light is eluted out using a spray-type developing device or a brush-type washing-out device whereupon a relief image can be formed on a support. This is dried and subjected to an active ray treatment whereupon a printing plate material can be resulted.

In the flexographic printing original plate according to the present invention, thickening of dots in a printing plate is suppressed. Specifically, in the flexographic printing original plate according to the present invention, the dot diameter in 1% screen area with 150 LPI satisfies the following formula [I]:

$$(\text{Dot diameter on relief}) \leq (\text{Dot diameter on negative film}) \qquad [\text{I}]$$

(Water-developable laminate of photosensitive resin)

The water-developable laminate of photosensitive resin for letterpress printing original plate according to the present invention is a laminate of photosensitive resin in which at least a support, an adhesive layer, a photosensitive resin layer and an adhesion-preventing layer are successively laminated, and is characterized in that the adhesion-preventing layer contains a cellulose derivative.

The support to be used for the laminate of photosensitive resin of the present invention is preferably made from a material being flexible and having a superior dimension stability, and examples thereof include: a support made of metal, such as steel, aluminum, copper and nickel, and a support made of a thermoplastic resin, such as a polyethylene terephthalate film, a polyethylene naphthalate film, a polybutylene terephthalate film and a polycarbonate film. Among these, the polyethylene terephthalate film, which has a superior dimension stability and a sufficiently high viscoelasticity, is in particular preferably used. The thickness of the support is set to 50 to 350 $\mu$m, preferably, to 100 to 250 $\mu$m, from the viewpoints of mechanical properties, shape stability and handling characteristics upon making a printing plate.

An adhesive layer used for the laminate of photosensitive resin according to the present invention is present between a support and a photosensitive resin layer and is installed for binding the both. An adhesive layer may be formed either by a single layer or by plural layers. In addition, it is preferred that an adhesive layer contains a binder component and a pigment and further contains a leveling agent and a curing agent.

As to a binder component used for an adhesive layer, there may be exemplified polyester resin, epoxy resin, polyamide resin, polyimide resin, phenol resin, butadiene resin, polyurethane resin and polystyrene-polyisoprene copolymer resin and each of them may be used either solely or jointly by mixing thereof. Particularly preferred binder components among the above are polyester resin and polyurethane resin in view of the resistance to solvents.

The photosensitive resin layer used for the laminate of photosensitive resin according to the present invention comprises a water-developable photosensitive resin which includes a water-soluble polymer compound, an ethylenic unsaturated compound and a photopolymerization initiator. Furthermore, the photosensitive resin layer may comprise other additives, such as a heat polymerization inhibitor, an ultraviolet-ray absorbing agent, a plasticizer, a dye, a pigment, perfume, and an antioxidant.

The above-mentioned water-soluble polymer compound is preferred to be a polymer compound which can be dissolved or dispersed in water or in a mixture of water with alcohol. Specific examples thereof include a polyether amide (cf. Japanese Patent Application Laid-Open (JP-A) No.79437/80), a polyether ester amide (cf. Japanese Patent Application Laid-Open (JP-A) No. 74537/80), a polyamide containing an ammonium salt type tertiary nitrogen atom (cf. Japanese Patent Application Laid-Open (JP-A) No. 36555/78) and a polyether urethane urea containing an ammonium salt type tertiary nitrogen atom (cf. Japanese Patent Application Laid-Open (JP-A) No. 97154/92). Among these polymer compounds, a polyamide containing an ammonium salt type tertiary nitrogen atom or a polyether urethane urea containing an ammonium salt type tertiary nitrogen atom is especially preferred.

The above-mentioned ethylenic unsaturated compound is a compound containing one or more photopolymerizable unsaturated group(s) in a molecule and the conventionally known ones may be used therefor. Examples of such compounds include polyhydric acrylate and methacrylate (being produced by addition reaction of polyhydric glycidyl ether to a compound having ethylenic unsaturated bond and active hydrogen such as unsaturated carboxylic acid or unsaturated alcohol) such as 2-hydroxyethyl acrylate, 2-hydroxypropyl acrylate, acrylamide, methacrylamide, N-methylolacrylamide, N-acroylmorpholine, pentaerythritol diacrylate, pentaerythritol triacrylate, glycerol dimethacrylate, ethylene glycol diglycidyl ether and trimethylolpropane triglycidyl ether; a product by addition reaction of an unsaturated epoxy compound such as glycidyl acrylate to a compound having active hydrogen such as carboxylic acid or amine; unsaturated polyester; and unsaturated polyurethane. Each of those monomers can be used either solely or jointly by mixing two or more thereof. Amount of such an ethylenic unsaturated compound contained in the photosensitive resin composition is preferred to be within a range of 5 to 50% by weight. When the amount is less than 5% by weight, curing property of the resin composition by light is disturbed while, when it is more than 50% by weight, there is a risk that a shape-holding property of a resin composition before exposure to light (original plate) is disturbed.

With regard to the above-mentioned photopolymerization initiator, all of the conventionally known photopolymerization initiators may be used. Specific examples thereof include benzoin alkyl ethers, benzophenones, anthraquinones, benzyls, acetophenones and diacetyls. It is preferred that the photopolymerization initiator is used within a range of 0.01 to 10% by weight in the photosensitive resin layer.

The above heat polymerization inhibitor is used for enhancing the thermal stability of a photosensitive resin layer. Specific examples of the heat polymerization inhibitor include phenols, hydroquinones and catechols. It is preferred that the heat polymerization initiator is used within a range of 0.001 to 5% by weight in the photosensitive resin layer.

Thickness of the photosensitive resin layer is preferred to be 0.1 to 10 mm. When thickness of the photosensitive resin layer is made 0.1 mm or more, a relief depth necessary for use as a printing plate material is achieved and, when it is made 10 mm or less, weight of the printing plate material is suppressed whereby there is resulted no practical insufficiency in handling.

The adhesion-preventing layer used in the laminate of photosensitive resin according to the present invention is formed on the surface of the photosensitive resin layer for preventing the tight adhesion of a negative film to the photosensitive resin layer and, among the persons skilled in the art, it is sometimes called a slip coat layer, a releasing layer or a coated layer as well. An adhesive layer may be formed between the photosensitive resin layer and the adhesion-preventing layer upon necessity. An adhesion-preventing layer may be compounded, if necessary, with inorganic fine particles such as silica, organic fine particles prepared by a three-dimensional internal crosslinking of polystyrene or acrylic monomer, surfactant, polyhydric alcohol, etc. in addition to a cellulose derivative.

As to a cellulose derivative, a water-soluble one is preferred and examples thereof include carboxymethyl cellulose, hydroxyethyl cellulose, hydroxypropyl cellulose, methyl cellulose, ethyl cellulose, ethyl hydroxyethyl cellulose and carboxymethyl ethyl cellulose. Among them, methyl cellulose is most preferred. Amount of the cellulose derivative contained in the adhesion-preventing layer is preferred to be 50 to 100% by mass and more preferred to be 70 to 100% by mass. Thickness of the adhesion-preventing layer is preferred to be within a range of 0.2 to 20 $\mu$m. As a result of making the thickness within such a range, an adhesion preventive effect can be well achieved without being affected by the photosensitive resin layer and, moreover, a sharp image can be formed.

It is necessary that an adhesion-preventing layer has a sufficient adhesive property to both of the photosensitive resin layer and the cover film. The sufficient adhesive property means such an adhesive property that, during the period when an adhesion-preventing layer is usually handled, adhesive property is exhibited to both of the photosensitive resin layer and the cover film and, before the image is exposed, the cover film can be easily removed. When a release-controlling layer is formed between the photosensitive resin layer and the adhesion-preventing layer, adhesive property between the photosensitive resin layer and the adhesion-preventing layer becomes much stronger. When a cellulose derivative is used in the adhesion-preventing layer, there is noted such an effect that removal of the original image film from the water-developable photosensitive resin printing plate material is made easy. In addition, a tight adhering property to the original image film is good and, as result, it is now possible to give a printing plate material having excellent reproducibility of the image and, particularly, exhibiting deep depth of the concave fine line. If the depth of the concave fine line is not appropriate, ink adheres even to such an area to which no ink should be adhered. Accordingly, depth of the concave fine line is an important factor for a printing plate material.

An adhesion-preventing layer has a role of working as preventing the adhesion of the surface of the photosensitive resin layer. When a release-controlling layer is formed between the photosensitive resin layer and the adhesion-preventing layer, it plays a role of making the release of the adhesion-preventing layer from the photosensitive resin layer difficult. Further, since any of those layers is eluted out and detached from the photosensitive resin layer upon the water-based developing, they do not remain on the plate surface after the developing. Accordingly, they do not affect during the printing.

As to a method of forming the adhesion-preventing layer on the photosensitive resin layer, there may be exemplified the following ones. For example, gravure coater, roll coater, curtain flow coater, spay or the like is used to apply a solution comprising a constituting component of the adhesion-preventing layer onto the photosensitive resin layer followed by drying. When the release-controlling layer is formed on the photosensitive resin layer, a solution for forming the release-controlling layer is firstly applied onto the photosensitive resin layer followed by drying and, after that, the adhesion-preventing layer is formed. For improving the applying/wetting property of the coat, a surfactant may be added, if necessary, to one or more layer (s) of the adhesion-preventing layer or the release-controlling layer. With regard to the surfactant, any type may be used so far as the adhesion-preventing layer and the release-controlling layer can be removed by the water-based developing and one or more surfactant(s) selected from anionic, nonionic and amphoteric ones may be used. The simplest method for forming the adhesion-preventing layer on the photosensitive resin layer is such a method wherein a solution comprising the constituting components for the adhesion-preventing layer is applied on a film used as a cover film for protecting the photosensitive resin layer followed by drying to form a thin coat and a cover film is subjected to contact bonding so that the coat contacts the photosensitive resin layer. When the release-controlling layer exists, a thin coat is prepared by application followed by drying of a solution containing the cellulose derivative and then a solution for forming a release-controlling layer is applied on the thin coat followed by drying to form a coat having a double-layered structure on the film. In a printing plate material having a cover film attached as such, since the whole coat is transcribed onto the photosensitive resin layer side upon releasing the cover film prior to exposure to the light of active ray, the adhesion-preventing layer becomes the surface of the plate whereupon the tight adhesion to the original image film becomes good. When a matted one is used as the cover film, the surface of the adhesion-preventing layer transcribed onto the photosensitive resin layer side is also in a state of being matted whereupon the tight adhesion of the original image film becomes very good.

As to the cover film as such, polyester film is the best one in view of the oxygen permeation rate and the dimensional stability. However, it is also possible to use polyethylene film, polypropylene film, acetate film, vinyl chloride film, cellophane, etc. Examples of a method for matting the film as such include sand blowing, chemical etching and coating of the resin containing a matting agent. It is also possible to use such a thing wherein resin is thinly applied onto a mat film being subjected to sand blowing or chemical etching so that the matting degree is adjusted.

The laminate of photosensitive resin according to the present invention can be prepared by conventionally known methods. For example, it can be prepared by such a method wherein a photosensitive resin layer is laminated on a support applied with an adhesive by means of lamination, casting or extrusion molding and a cover film to which an adhesion-preventing layer is applied is tightly adhered onto the photosensitive resin layer. It is also possible that a known adhesion-preventing layer or a protective cover film is laminated for making the plate-making easy. It is further possible to prepare a laminate of photosensitive resin by such a means wherein a photosensitive resin composition is sandwiched between a support and a cover film and pushed using a heating press or the like until the necessary thickness is achieved.

For a purpose of forming a relief image for printing on the laminate of photosensitive resin according to the present invention, ultraviolet ray is firstly irradiated from a support side with a light source having usually 300 to 400 nm wavelength such as, for example, high-voltage mercury lamp, ultrahigh-voltage mercury lamp, metal halide lamp, xenon lamp, carbon arc lamp or chemical lamp, then a negative or positive original image film is tightly attached onto a photosensitive resin layer wherefrom a cover film is released followed by subjecting to an ultraviolet ray irradiation and subjected to a photo-curing by means of photopolymerization.

After that, unexposed area is eluted using a spray-type developing device or a brush-type washing device whereupon a relief image can be formed on a support. This is dried and then subjected to a treatment with active ray whereupon a printing plate material is obtained.

When the laminate of photosensitive resin according to the present invention is used, the following points are improved as compared with the conventional products:

(1) Even when the adhesive property of the photosensitive resin layer itself is strong, an adhesion-preventing layer using a cellulose derivative is formed on the whole surface contacting the original image film whereby a tight adhesion of the original image film is easy;

(2) As a result of using a cellulose derivative in the adhesion-preventing layer, the image reproducibility or, particularly, depth of the concave fine line of the resulting relief can be made deep; and

(3) As a result of using a cellulose derivative in the adhesion-preventing layer, adhesion of a plate surface hardly happens on the tightly adhered surface of the original image film as compared with the conventional adhesive-preventing layer made of PVA. In addition, poor release of the cover under the condition of high temperature and high humidity rarely happens whereby the stability with elapse of time is excellent.

The printing plate material using the laminate of photosensitive resin according to the present invention gives a photosensitive resin plate for printing which is excellent in its image reproducibility and is particularly excellent in the reproducibility to the original image film. Specifically, the dot diameter on a relief which has been produced by using the laminate of photosensitive resin according to the present invention as a printing original plate and by using an original drawing film satisfies the following formula [II] in terms of reproducibility to the original image film:

$$\text{(Dot diameter on relief)} \leq \text{(Dot diameter on original image film)} \quad \text{[II]}$$

When the dot diameters on relief wherein plate-making is conducted using the same original image film are measured and compared in terms of reproducibility to the original image film, it is preferred that the dot diameter on relief in 1% screen area with 150 LPI is not more than the dot diameter on original image film and is more preferred that it is within a range of from the same as the dot diameter on original image film to 80% of the dot diameter on original image film.

Examples

The present invention will now be specifically illustrated by way of the following Examples although the present invention is not limited thereto. Incidentally, methods for evaluating the items evaluated in Examples 1 to 8 and Comparative Examples 1 to 7 will be shown below.

(1) Dot diameter in 1% screen area with 150 LPI

Dot diameter in 1% screen area with 150 LPI was measured using a laser microscope VF 9500 manufactured by Keyence. Incidentally, the dot diameter on a negative film used for the evaluation was 19 $\mu$m.

(2) Solvent-resisting ink property

After a plate was dipped for 24 hours in a solution of IPA/propyl acetate = 80/20, evaluation was conducted in terms of the swelling rate after the dipping.

| less than 10% | $\rightarrow$ | ○ |
| 10% to 20% | $\rightarrow$ | ○Δ |
| 20% to 30% | $\rightarrow$ | Δ |

(continued)

| 30% to 40% | $\rightarrow$ | $\Delta\times$ |
|---|---|---|
| more than 40% | $\rightarrow$ | $\times$ |

(Preparation of photosensitive resin composition A)

91 parts by mass of butadiene latex (LX111NF manufactured by Nippon Zeon; solid concentration: 55%) as latex;
15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;
1 part by mass of benzyl dimethylketal as a photopolymerization initiator;
20 parts by mass of PFT-3 (a polymer of number-average molecular weight of ca. 20, 000 having a urethaneurea structure manufactured by Kyoeisha Kagaku; solid concentration: 25%) as a hydrophilic polymer;
0.1 part by mass of hydroquinone monomethyl ether as a polymerization inhibitor; and
9 parts by mass of liquid butadiene as a plasticizer

were mixed in a container together with 5 parts by mass of toluene and kneaded at 105°C using a pressurizing kneader and, after that, toluene and water were removed therefrom in *vacuo* to give a photosensitive resin composition A.

(Preparation of photosensitive resin composition B)

73 parts by mass of butadiene latex (LX111NF manufactured by Nippon Zeon; solid concentration: 55%) and 24 parts by mass of acrylonitrile-butadiene latex (SX1503A manufactured by Nippon Zeon; solid concentration: 42%) as latices;
15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;
1 part by mass of benzyl dimethylketal as a photopolymerization initiator;
20 parts by mass of PFT-3 (a polymer of number-average molecular weight of ca. 20, 000 having a urethaneurea structure manufactured by Kyoeisha Kagaku; solid concentration: 25%) as a hydrophilic polymer;
0.1 part by mass of hydroquinone monomethyl ether as a polymerization inhibitor; and
9 parts by mass of liquid butadiene as a plasticizer

were mixed in a container together with 5 parts by mass of toluene and kneaded at 105°C using a pressurizing kneader and, after that, toluene and water were removed therefrom in *vacuo* to give a photosensitive resin composition B.

(Preparation of photosensitive resin composition C)

55 parts by mass of butadiene latex (LX111NF manufactured by Nippon Zeon; solid concentration: 55%) as latex;
35 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;
1 part by mass of benzyl dimethylketal as a photopolymerization initiator;
20 parts by mass of PFT-3 (a polymer of number-average molecular weight of ca. 20,000 having a urethaneurea structure manufactured by Kyoeisha Kagaku; solid concentration: 25%) as a hydrophilic polymer;
0.1 part by mass of hydroquinone monomethyl ether as a polymerization inhibitor; and
9 parts by mass of liquid butadiene as a plasticizer

were mixed in a container together with 5 parts by mass of toluene and kneaded at 105°C using a pressurizing kneader and, after that, toluene and water were removed therefrom *in vacuo* to give a photosensitive resin composition C.

(Preparation of photosensitive resin composition D)

100 parts by mass of carboxy-modified methyl methacrylate-butadiene latex (MR174 manufactured by Nippon A&L; solid concentration: 50%) as latex;
15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;
1 part by mass of benzyl dimethylketal as a photopolymerization initiator;
20 parts by mass of PFT-3 (a polymer of number-average molecular weight of ca. 20,000 having a urethaneurea structure manufactured by Kyoeisha Kagaku; solid concentration: 25%) as a hydrophilic polymer;
0.1 part by mass of hydroquinone monomethyl ether as a polymerization inhibitor; and
9 parts by mass of liquid butadiene as a plasticizer

were mixed in a container together with 5 parts by mass of toluene and kneaded at 105°C using a pressurizing kneader and, after that, toluene and water were removed therefrom *in vacuo* to give a photosensitive resin composition D.

(Preparation of photosensitive resin composition E)

71 parts by mass of styrene-butadiene latex (Nipol C4850 manufactured by Nippon Zeon; solid concentration: 70%) as latex;
15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;
1 part by mass of benzyl dimethylketal as a photopolymerization initiator;
20 parts by mass of PFT-3 (a polymer of number-average molecular weight of ca. 20, 000 having a urethaneurea structure manufactured by Kyoeisha Kagaku; solid concentration: 25%) as a hydrophilic polymer;
0.1 part by mass of hydroquinone monomethyl ether as a polymerization inhibitor; and
9 parts by mass of liquid butadiene as a plasticizer

were mixed in a container together with 5 parts by mass of toluene and kneaded at 105°C using a pressurizing kneader and, after that, toluene and water were removed therefrom *in vacuo* to give a photosensitive resin composition E.

(Preparation of photosensitive resin composition F)

100 parts by mass of acrylonitrile-butadiene latex (NA105 manufactured by Nippon A&L; solid concentration: 50%) as latex;
15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;
1 part by mass of benzyl dimethylketal as a photopolymerization initiator;
20 parts by mass of PFT-3 (a polymer of number-average molecular weight of ca. 20, 000 having a urethaneurea structure manufactured by Kyoeisha Kagaku; solid concentration: 25%) as a hydrophilic polymer;
0.1 part by mass of hydroquinone monomethyl ether as a polymerization inhibitor; and
9 parts by mass of liquid butadiene as a plasticizer

were mixed in a container together with 5 parts by mass of toluene and kneaded at 105°C using a pressurizing kneader and, after that, toluene and water were removed therefrom *in vacuo* to give a photosensitive resin composition F.

(Preparation of photosensitive resin composition G)

119 parts by mass of acrylonitrile-butadiene latex (SX1503A manufactured by Nippon Zeon; solid concentration: 42%) as latex;

15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;

1 part by mass of benzyl dimethylketal as a photopolymerization initiator;

20 parts by mass of PFT-3 (a polymer of number-average molecular weight of ca. 20,000 having a urethaneurea structure manufactured by Kyoeisha Kagaku; solid concentration: 25%) as a hydrophilic polymer;

0.1 part by mass of hydroquinone monomethyl ether as a polymerization inhibitor; and

9 parts by mass of liquid butadiene as a plasticizer

were mixed in a container together with 5 parts by mass of toluene and kneaded at 105°C using a pressurizing kneader and, after that, toluene and water were removed therefrom *in vacuo* to give a photosensitive resin composition G.

(Preparation of photosensitive resin composition H)

50 parts by mass of solid butadiene rubber (BR022 manufactured by Japan Synthetic Rubber Co,. Ltd.; solid concentration: 100%);

15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;

1 part by mass of benzyl dimethylketal as a photopolymerization initiator;

20 parts by mass of PFT-3 (a polymer of number-average molecular weight of ca. 20, 000 having a urethaneurea structure manufactured by Kyoeisha Kagaku; solid concentration: 25%) as a hydrophilic polymer;

0.1 part by mass of hydroquinone monomethyl ether as a polymerization inhibitor; and

9 parts by mass of liquid butadiene as a plasticizer

were mixed in a container together with 5 parts by mass of toluene and kneaded at 105°C using a pressurizing kneader and, after that, toluene and water were removed therefrom *in vacuo* to give a photosensitive resin composition H.

(Preparation of photosensitive resin composition I)

36 parts by mass of butadiene latex (LX111NF manufactured by Nippon Zeon; solid concentration: 55%) as latex;

30 parts by mass of solid butadiene rubber (BR022 manufactured by Japan Synthetic Rubber Co,. Ltd.; solid concentration: 100%);

15 parts by mass of oligobutadiene acrylate (ABU-3 manufactured by Kyoeisha Kagaku; number-average molecular weight: 2700), 10 parts by mass of lauryl methacrylate and 10 parts by mass of trimethylolpropane trimethacrylate as photopolymerizable compounds;

1 part by mass of benzyl dimethylketal as a photopolymerization initiator;

20 parts by mass of PFT-3 (a polymer of number-average molecular weight of ca. 20,000 having a urethaneurea structure manufactured by Kyoeisha Kagaku; solid concentration: 25%) as a hydrophilic polymer;

0.1 part by mass of hydroquinone monomethyl ether as a polymerization inhibitor; and

9 parts by mass of liquid butadiene as a plasticizer

were mixed in a container together with 5 parts by mass of toluene and kneaded at 105°C using a pressurizing kneader and, after that, toluene and water were removed therefrom *in vacuo* to give a photosensitive resin composition I.

Example 1

(Manufacture of flexographic printing original plate)

After methyl cellulose (SM 15 manufactured by Shin-Etsu Chemical) was dissolved in a mixed solvent of water and isopropyl alcohol, it was applied on a matte-treated PET film (thickness: 100 $\mu$m) and dried whereupon a cover film equipped with an adhesion-preventing layer was obtained. Thickness of the adhesion-preventing layer was 1.2 $\mu$m.

After that, the photosensitive resin composition mentioned in Table 1 was arranged on a PET film support applied with a copolymerized polyester-based adhesive and the cover film equipped with an adhesion-preventing film is layered thereon followed by laminating at 100°C using a heat press machine. As such, a flexographic printing original plate comprising a PET support, an adhesive layer, a photosensitive layer, an adhesion-preventing layer and a cover film was obtained. Total thickness of the plate was 1.7 mm.

(Manufacture of printing plate from flexographic printing original plate)

First, chemical ray (light source: Philips 10R; illumination at 365 nm: 8 mW/cm$^2$) was irradiated for one minute from the PET support side of the original plate in order to form a floor layer. After that, the cover film was released therefrom. After that, a negative film was tightly adhered onto the adhesion-preventing layer *in vacuo* and chemical ray (light source: Philips 10R; illumination at 365 nm: 8 mW/cm$^2$) was irradiated thereon for six minutes. After that, development was carried out at 40°C for eight minutes using a developing device (Stuck System) manufactured by A&V. Tap water to which 1% of Cascade (detergent for tableware manufactured by P&G) was added was used as a developer. After developing, it was dried at 60°C for ten minutes, chemical ray was irradiated thereon for ten minutes and, finally, a germicidal lamp was irradiated thereon for five minutes for removing the stickiness on the surface. Result of evaluation of the printing plate is shown in Table 1.

Example 2

The same manufacture and evaluation as in Example 1 were conducted except that methyl cellulose (SM 4 manufactured by Shin-Etsu Chemical, low-viscosity type) was used as an adhesion-preventing composition.

Example 3

The same manufacture and evaluation as in Example 1 were conducted except that a plasticizer (aliphatic polyhydric alcohol-based polyether polyol; SE 270 manufactured by Sanyo Kasei) was compounded as an adhesion-preventing composition in addition to methyl cellulose.

Example 4

The same manufacture and evaluation as in Example 1 were conducted except that hydroxypropyl methyl cellulose (60SH-15 manufactured by Shin-Etsu Chemical) was used as an adhesion-preventing composition.

Example 5

The same manufacture and evaluation as in Example 1 were conducted except that a photosensitive resin composition B was used in a photosensitive resin layer.

Example 6

The same manufacture and evaluation as in Example 1 were conducted except that a photosensitive resin composition C was used in a photosensitive resin layer.

Example 7

The same manufacture and evaluation as in Example 1 were conducted except that a photosensitive resin composition D was used in a photosensitive resin layer.

Example 8

The same manufacture and evaluation as in Example 1 were conducted except that a photosensitive resin composition E was used in a photosensitive resin layer.

Comparative Example 1

The same manufacture and evaluation as in Example 1 were conducted except that a photosensitive resin composition F was used in a photosensitive resin layer.

Comparative Example 2

The same manufacture and evaluation as in Example 1 were conducted except that a photosensitive resin composition G was used in a photosensitive resin layer.

Comparative Example 3

The same manufacture and evaluation as in Example 1 were conducted except that a photosensitive resin composition H was used in a photosensitive resin layer.

Comparative Example 4

The same manufacture and evaluation as in Example 1 were conducted except that a photosensitive resin composition I was used in a photosensitive resin layer.

Comparative Example 5

The same manufacture and evaluation as in Example 1 were conducted except that polyvinyl alcohol of high saponification degree (PVA 117 manufactured by Kuraray) was used as an adhesion-preventing composition.

Comparative Example 6

The same manufacture and evaluation as in Example 1 were conducted except that polyvinyl alcohol of low saponification degree (PVA 505 manufactured by Kuraray) was used as an adhesion-preventing composition.

Comparative Example 7

The same manufacture and evaluation as in Example 1 were conducted except that polyvinyl alcohol of high saponification degree (PVA 117 manufactured by Kuraray) was used as an adhesion-preventing composition and that a photosensitive resin composition B was used in a photosensitive resin layer.

Details and evaluating result of the printing original plate of Examples 1 to 8 and Comparative Examples 1 to 7 prepared as above are shown in Table 1.

[Table 1]

| | Resin composition No. | Photosensitive resin layer | | | Average gelation degree (%) | Adhesion-preventing layer | Dot diameter in 1% screen area with 150 LPI (μm) | Solvent-resisting ink property |
|---|---|---|---|---|---|---|---|---|
| | | Latex | | | | Constituting components (% by mass) | | |
| | | Kinds | Gelation degree (% by mass) | Content (% by mass) | | | | |
| Example 1 | A | LX111NF | 86 | 50 | 86 | Methyl cellulose (SM 15) 100% by mass | 18 | ○ |
| Example 2 | A | LX111NF | 86 | 50 | 86 | Methyl cellulose (SM 4) 100% by mass | 18 | ○ |
| Example 3 | A | LX111NF | 86 | 50 | 86 | Methyl cellulose (SM 15) 90% by mass + plasticizer 10% by mass | 18 | ○ |
| Example 4 | A | LX111NF | 86 | 50 | 86 | Hydroxypropyl methyl cellulose (60SH15) 100% by mass | 19 | ○ |
| Example 5 | B | LX111NF / SX1503A | 86 / 0 | 40 / 10 | 69 | Methyl cellulose (SM 15) 100% by mass | 17 | ○△ |
| Example 6 | C | LX111NF | 86 | 30 | 86 | Methyl cellulose (SM 15) 100% by mass | 17 | △ |
| Example 7 | D | MR174 | 95 | 50 | 95 | Methyl cellulose (SM 15) 100% by mass | 18 | ○ |
| Example 8 | E | Nipol C4850 | 60 | 50 | 60 | Methyl cellulose (SM 15) 100% by mass | 18 | △ |
| Comparative Example 1 | F | NA105 | 35 | 50 | 35 | Methyl cellulose (SM 15) 100% by mass | 18 | △× |
| Comparative Example 2 | G | SX1503A | 0 | 50 | 0 | Methyl cellulose (SM 15) 100% by mass | 18 | × |
| Comparative Example 3 | H | BR022 | - | 50 | - | Methyl cellulose (SM 15) 100% by mass | 18 | × |
| Comparative Example 4 | I | LX111NF | 86 | 20 | 86 | Methyl cellulose (SM 15) 100% by mass | 18 | △× |

(continued)

| | Resin composition No. | Photosensitive resin layer | | | | Adhesion-preventing layer | Dot diameter in 1% screen area with 150 LPI (μm) | Solvent-resisting ink property |
| | | Latex | | | | Constituting components (% by mass) | | |
| | | Kinds | Gelation degree (% by mass) | Content (% by mass) | Average gelation degree (%) | | | |
| Comparative Example 5 | A | LX111NF | 86 | 50 | 86 | Polyvinyl alcohol (high saponification) 100% by mass | 24 | ○ |
| Comparative Example 6 | A | LX111NF | 86 | 50 | 86 | Polyvinyl alcohol (low saponification) 100% by mass | 23 | ○ |
| Comparative Example 7 | B | LX111NF | 86 | 40 | 69 | Polyvinyl alcohol (high saponification) 100% by mass | 23 | ○ |
| | | SX1503A | 0 | 10 | | | | |

LX111 NF: butadiene latex (manufactured by Nippon Zeon) gelation degree 86% SX1503A: NBR latex (manufactured by Nippon Zeon) gelation degree 0% MR174: carboxy-modified MB latex (manufactured by Nippon A&L) gelation degree 95% Nipol C4850: SBR latex (manufactured by Nippon Zeon) gelation degree 60% NA105: NBR latex (manufactured by Nippon A&L) gelation degree 35% BR02: butadiene rubber (manufactured by Japan Synthetic Rubber Co,. Ltd.) gelation degree 0% Plasticizer: SE270 (manufactured by Sanyo Kasei) aliphatic polyhydric alcohol-based polyether polyol, oxyethyleneol-modified product of hexane-1,2,3,4,5,6-hexaol, number-average molecular weight: 500

As will be apparent from Table 1, when the latex having a high gelation degree is used in a photosensitive resin layer and the cellulose derivative is used in an adhesion-preventing layer as shown in Examples 1 to 8, there is prepared a plate wherein thickening of dots in the printing plate does not happen and solvent-resisting ink property is excellent. In Example 3, a plasticizer was compounded with an adhesion-preventing layer and, even when a rough handling was done, no wrinkle was generated on the plate surface. On the other hand, when the latex having a low gelation degree or being non-gelled was used as shown in Comparative Examples 1 to 3, although no thickening of dots in a printing plate was noted, solvent-resisting ink property was insufficient. Even when the latex having a high gelation degree was compounded as shown in Comparative Example 4, solvent-resisting property was inferior when the compounding amount was small. When polyvinyl alcohol was used in an adhesion-preventing layer as shown in Comparative Examples 5 to 7, thickening of dots in the printing plate was significantly generated.

(Preparation of photosensitive resin composition A')

ε-Caprolactam (55.0 parts by mass), 40.0 parts by mass of N, N-bis (γ-aminopropyl)piperazine adipate, 7.5 parts by mass of 1,3-bisaminomethylcyclohexane adipate and 100 parts by mass of water were charged in a reactor, tightly closed after sufficient substitution with nitrogen and gradually heated. Starting from the stage when the inner pressure reached 10 kg/cm$^2$, water in the reactor was gradually distilled, the inner pressure was returned to atmospheric pressure during 1 hour and then the reaction was conducted at atmospheric pressure for 1.0 hour to give a transparent and light yellow polyamide containing tertiary nitrogen atom.

After that, 50.0 parts by mass of the resulting polyamide, 50.0 parts by mass of methanol and 10.0 parts by mass of water were mixed at 60°C for 2 hours in a heating/dissolving reactor equipped with a stirrer whereupon the polymer was completely dissolved. Then 44.0 parts by mass of an adduct of trimethylolpropane triglycidyl ester with acrylic acid, 3 parts by mass of methacrylic acid, 0.1 part by mass of hydroquinone monomethyl ether, 0.02 part by mass of 2,2',4,4'-tetrahydroxybenzophenone and 2 parts by mass of benzyl methylketal were added thereto followed by stirring for 30 minutes to dissolve. After that, methanol and water were evaporated by gradually raising the temperature and concentration was conducted until the temperature in the reactor reached 110°C to give a photosensitive resin composition A' containing a fluid and viscous polyamide containing ammonium salt type tertiary nitrogen atom.

(Preparation of photosensitive resin composition B')

N,N'-bis(3-aminopropyl)piperazine (77 parts by mass) and 22 parts by mass of 2-methylpentamethylenediamine were dissolved in 550 parts by mass of methanol. After that, 451 parts by mass of a urethane oligomer substantially having isocyanate groups at both ends thereof prepared by the reaction of 600 parts by mass of polyethylene glycol (average molecular weight: 600) with 369 parts by mass of hexamethylene diisocyanate was gradually added with stirring to the above-prepared diamine solution. Reaction of the both finished within about 15 minutes under the condition wherein the polymer solid concentration was 50%. This solution was taken into a culture dish coated with Teflon (registered trade mark), methanol was removed therefrom by evaporation and the residue was dried *in vacuo* to give a polyether ureaurethane having 1.71 specific viscosity and containing 20% by mass of 2-methylpenta- methylenediamine and 47% by mass of a polyether segment in diamine component.

After that, 55.0 parts by mass of the resulting polyether ureaurethane and 2.1 parts by mass of benzoic acid as a quaternizing agent were dissolved in 200.0 parts by mass of methanol and 10 parts by mass of water and subjected to a quaternizing reaction at 65°C for 4 hours in a heating reactor equipped with a stirrer. Then 33.7 parts by mass of glycerol dimethacrylate, 5 parts by mass of ethylene glycol diepoxyacrylate, 3.1 parts by mass of N-ethyltoluenesulfonic acid amide as a plasticizer, 0.1 part by mass of hydroquinone monoethyl ether and 1.0 part by mass of benzyl dimethylketal were added to give a solution of photosensitive resin composition containing polyether urethaneurea containing ammonium salt type tertiary nitrogen atom. After that, methanol and water were evaporated by gradually raising the temperature and concentration was conducted until the temperature in the reactor reached 110°C to give a photosensitive resin composition B' containing a fluid and viscous polyether urethane urea containing ammonium salt type tertiary nitrogen atom.

Example 1'

(Preparation of cover film provided with adhesion-preventing layer)

After methyl cellulose (SM 15 manufactured by Shin-Etsu Chemical) was dissolved in a mixed solvent of water and isopropyl alcohol, it was applied on a PET film (thickness: 125 μm) and dried whereupon a cover film equipped with an adhesion-preventing layer was obtained. Thickness of the adhesion-preventing layer was 1.2 μm.

(Preparation of a laminate of photosensitive resin)

A photosensitive resin composition A' was arranged on the PET film support applied with a copolymerized polyester adhesive (20 μm), the cover film equipped with the adhesion-preventing layer was laid thereon so as to face the adhesion-preventing layer thereon and lamination was conducted at 110°C using a heat press machine. This laminate can be used as a sheet-form photosensitive resin original plate of 1075 μm total thickness, which can be used in a letterpress printing machine.

(Preparation of relief plate for printing)

The cover film of the laminate of photosensitive resin prepared as above was released, an original image film was laid thereon, exposure to light was conducted to the exposed photosensitive resin layer and developing was conducted with water of 25°C using an automatic brush developing machine (JOW-A2-PD manufactured by Nippon Denshi Seiki) to conduct the plate-making. When there was no residue of the photosensitive resin after washing by the developing, the above was taken out from the automatic brush developing machine, water was swished off and drying was conducted at 60°C for 10 minutes to prepare a relief plate for printing.

The resulting relief plate for printing was used and dot diameter in 1% screen area with 150 LPI was observed using a laser microscope (VK-9500, a microscope for measuring the color 3D shape of super depth color; manufactured by Keyence). It was evaluated that in what μm the dot diameter in 1% screen area with 150 LPI after plate-making was reproduced for 20 μm of dot diameter on original image film in 1% screen area with 150 LPI.

Further, when the photosensitive resin layer was cured in a plate-making step for the resulting relief plate for printing, the shortest exposing time (minute(s)) required for reproduction of dot in 1% screen area with 150 LPI and 30-μm fine line was measured and recorded.

Furthermore, when the cover film was removed from the laminate of photosensitive resin in a plate-making step and the original image film was placed on the surface of the plate in the resulting relief plate for printing, it was checked whether adhesive property was exhibited on the surface of the adhesion-preventing layer. With regard to the plate used for the evaluation, that which was previously stored for a long period of time under the condition of 30°C temperature and 90% humidity was used.

Still further, with regard to the resulting relief plate for printing, it was checked whether the removal of the cover can be smoothly carried out when a cover film was removed in a plate-making step. With regard to the plate used for the evaluation, that which was previously stored for a long period of time under the condition of 30°C temperature and 90% humidity was used.

Example 2'

A laminate of photosensitive resin was prepared and evaluated by the same method as in Example 1' except that the photosensitive resin composition used for a photosensitive resin layer was changed to a photosensitive resin composition B as mentioned in Table 2.

Example 3'

A laminate of photosensitive resin was prepared and evaluated by the same method as in Example 1' except that methyl cellulose used for the adhesion-preventing layer was changed to hydroxypropyl cellulose as mentioned in Table 2.

Example 4'

A laminate of photosensitive resin was prepared and evaluated by the same method as in Example 1' except that SE270 (manufactured by Sanyo Chemical Industries) was added as a plasticizer in a total weight ratio of 0.5% to a composition of the methyl cellulose solution used for the adhesion-preventing layer.

Example 5'

A laminate of photosensitive resin was prepared and evaluated by the same method as in Example 3' except that SE270 (manufactured by Sanyo Chemical Industries) was added as a plasticizer in a total weight ratio of 0.5% to a composition of hydroxypropyl cellulose solution used for the adhesion-preventing layer.

Comparative Example 1'

A laminate of photosensitive resin was prepared and evaluated by the same method as in Example 1' except that methyl cellulose used for the adhesion-preventing layer was changed to polyvinyl alcohol of a high saponification degree (AH-26 manufactured by Nippon Synthetic Chemical Industry; saponification degree was 97 molar % or more) as mentioned in Table 2.

Comparative Example 2'

A laminate of photosensitive resin was prepared and evaluated by the same method as in Example 1' except that methyl cellulose used for the adhesion-preventing layer was changed to polyvinyl alcohol of a low saponification degree (KP-08R manufactured by Nippon Synthetic Chemical Industry; saponification degree was 71 to 72.5 molar %) as mentioned in Table 2.

Details and evaluating result of the laminate of photosensitive resin of Examples 1' to 5' and Comparative Examples 1' and 2' are shown in Table 2.

[Table 2]

| | Photosensitive resin composition | Composition of adhesion-preventing layer | Dot diameter on relief ($\mu$m) | Exposing time (minute(s)) | Adhesive property of original image film plate surface | Cover releasing property under high humidity |
|---|---|---|---|---|---|---|
| Example 1' | A' | Methyl cellulose | 16 | 10 | Absent | Absent |
| Example 2' | B' | Methyl cellulose | 16 | 6 | Absent | Absent |
| Example 3' | A' | Hydroxypropyl cellulose | 16 | 10 | Absent | Absent |
| Example 4' | A' | Methyl cellulose+SE270 (0.5%) | 16 | 10 | Absent | Absent |
| Example 5' | A' | Hydroxypropyl cellulose +SE270 (0.5%) | 16 | 10 | Absent | Absent |
| Comparative Example 1' | A' | Polyvinyl alcohol of a high saponification degree | 22 | 10 | Present | Present |
| Comparative Example 2' | A' | Polyvinyl alcohol of a low saponification degree | 22 | 10 | Present | Present |

As will be noted from Table 2, a relief for printing prepared from the laminates of photosensitive resin of Examples 1' to 5' could reproduce a smaller dot diameter in 1% screen area with 150 LPI than the dot diameter on original image film in 1% screen area with 150 LPI used for the plate-making and also could satisfy the cover releasing property under high humidity. On the contrary, in Comparative Examples 1' and 2' using polyvinyl alcohol, none of the characteristics of a dot diameter on relief, an adhesive property of original image film plate surface and a cover releasing property under high humidity was satisfactory.

Industrial Applicability

Since the flexographic printing original plate according to the present invention fulfills both of the solvent-resisting ink property and the suppression of dot thickening, it is particularly useful as a plate material for high-quality printing suitable for film printing. In accordance with the laminate of the photosensitive resin of the present invention, it is possible to prepare a printing relief which reproduces more precise pattern than the original image film whereby it is now possible to give a printed thing which is nearer the original image film. Since the conventional product has such a property wherein the printed relief faithfully reproduced the original image film, there is a disadvantage that the resulting printed thing becomes thicker. In accordance with the present invention, it is now possible to finish a precise printed thing being near the original image film. The present invention is an art meeting the requirements for high-quality printing in recent years and its possibility in contributing in industry is high.

## Claims

1. A photosensitive flexographic printing original plate being developable by water in which at least a support, a photosensitive resin layer containing 25% by mass or more of latex having gelation degree of 55% or more and an adhesion-preventing layer are successively laminated, **characterized in that** the adhesion-preventing layer contains a cellulose derivative.

2. The flexographic printing original plate according to claim 1, wherein weight-average gelation degree of total latex in the photosensitive resin layer is 55% or more.

3. The flexographic printing original plate according to claim 1 or 2, wherein the cellulose derivative is methyl cellulose.

4. The flexographic printing original plate according to any of claims 1 to 3, wherein the adhesion-preventing layer contains, besides the cellulose derivative, a plasticizer which is a compound having 3 to 8 hydroxyl groups in a molecule and having number-average molecular weight of 120 to 1000.

5. The flexographic printing original plate according to any of claims 1 to 4, wherein the dot diameter in 1% screen area with 150 LPI satisfies the following formula [I]:

$$\text{(Dot diameter on relief)} \leq \text{(Dot diameter on negative film)}$$

$$[\text{I}]$$

## Patentansprüche

1. Photosensitive Flexodruck-Originalplatte, welche durch Wasser entwickelbar ist, in welcher mindestens ein Träger, eine photosensitive Harzschicht, enthaltend 25 Massenprozent oder mehr eines Latex mit einem Geliergrad von 55% oder mehr, und eine Schicht zur Vermeidung von Anhaftung nachfolgend laminiert sind, **dadurch gekennzeichnet, daß** die Schicht zur Vermeidung von Anhaftung ein Cellulosederivat enthält.

2. Flexodruck-Originalplatte nach Anspruch 1, wobei ein gewichtsgemittelter Gelierungsgrad der Gesamtmenge an Latex in der photosensitiven Harzschicht 55% oder mehr beträgt.

3. Flexodruck-Originalplatte nach Anspruch 1 oder 2, wobei das Cellulosederivat Methylcellulose ist.

4. Flexodruck-Originalplatte nach einem der Ansprüche 1 bis 3, wobei die Schicht zur Vermeidung von Anhaftung neben dem Cellulosederivat, einen Weichmacher enthält, welcher eine Verbindung mit 3 bis 8 Hydroxylgruppen in einem Molekül ist und ein zahlengemitteltes Molekulargewicht von 120 bis 1000 aufweist.

5. Flexodruck-Originalplatte nach einem der Ansprüche 1 bis 4, wobei der Punkt-Durchmesser in einem 1% Rasterbereich mit 150 Linien pro Zoll (LPI) der folgenden Formel (I) genügt:

$$\text{(Punkt-Durchmesser auf Relief)} \leq \text{(Punkt-Durchmesser auf Negativfilm) [I].}$$

## Revendications

1. Plaque originale d'impression flexographique photosensible apte au développement par l'eau, dans laquelle au moins un support, une couche de résine photosensible contenant une proportion égale ou supérieure à 25 % en masse d'un latex ayant un degré de gélification égal ou supérieur à 55 % et une couche de prévention d'adhérence sont stratifiés successivement, **caractérisée en ce que** la couche de prévention d'adhérence contient un dérivé de cellulose.

2. Plaque originale d'impression flexographique suivant la revendication 1, dans laquelle la moyenne en poids du degré de gélification du latex total dans la couche de résine photosensible est égale ou supérieure à 55 %.

3. Plaque originale d'impression flexographique suivant la revendication 1 ou 2, dans laquelle le dérivé de cellulose est la méthylcellulose.

4. Plaque originale d'impression flexographique suivant l'une quelconque des revendications 1 à 3, dans laquelle la couche de prévention d'adhérence contient, en plus du dérivé de cellulose, un plastifiant qui est un composé ayant 3 à 8 groupes hydroxyle dans la molécule et ayant une moyenne en nombre du poids moléculaire de 120 à 1000.

5. Plaque originale d'impression flexographique suivant l'une quelconque des revendications 1 à 4, dans laquelle le diamètre de point dans une surface de trame de 1 % avec 150 LPI satisfait la formule [I] suivante :

$$\text{(diamètre de point sur relief)} \leq \text{(diamètre de point sur film négatif)}$$

$$[\,\mathrm{I}\,]$$

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005077503 A
- WO 2004090638 A
- JP 52110010 A
- JP 2004295120 A
- JP 5072740 A
- JP 2003295422 A
- JP 2004264509 A
- JP 55079437 A
- JP 55074537 A
- JP 53036555 A
- JP 4097154 A